# EUROPÄISCHE PATENTSCHRIFT

(11) **EP 2 085 785 B1**
(45) Veröffentlichungstag und Bekanntmachung des Hinweises auf die Patenterteilung: **21.10.2015**
(21) Anmeldenummer: 09151632.8
(22) Anmeldetag: 29.01.2009
(51) Int. Cl.: G01R 31/36, G01R 1/20, H01R 11/28

(54) **Vorrichtung zur Strommessung**
Device for measuring electricity
Dispositif destiné à la mesure du courant

(30) Priorität: 31.01.2008 DE 102008006866
(43) Veröffentlichungstag der Anmeldung: 05.08.2009
(73) Patentinhaber: Hella KGaA Hueck & Co., 59552 Lippstadt (DE)
(72) Erfinder: Opgen-Rhein, Peter, 59329, Wadersloh (DE); Schöllmann, Matthias, 33100, Paderborn (DE); Unterhalt, Marco, 33154, Salzkotten (DE)

(56) Entgegenhaltungen:
- DE-A1- 19 961 311
- DE-A1-102004 055 847
- DE-A1-102006 019 497
- DE-B3-102004 046 855
- US-A1- 2007 194 747

## Beschreibung

Die Erfindung betrifft eine Vorrichtung zur Strommessung gemäß dem Oberbegriff des Anspruchs 1.

Solche Vorrichtungen werden in Kraftfahrzeugen eingesetzt, um einen Zustand eines Akkumulators zu prüfen sowie zu überwachen. Sie sind an sich bekannt. Sie weisen z.B. einen Shunt, das ist ein niederohmiger Messwiderstand, und eine Auswerteelektronik mit Ausgängen auf.

Die DE 103 33 035 A1 beschreibt eine Sensoreinrichtung für ein Kraftfahrzeug, bei der mindestens ein Anschlusskabel über ein Gehäuse eingeführt ist. Das Anschlusskabel erlaubt eine Befestigung des Gehäuses. Die Sensoreinrichtung und die Montage des mindestens einen Anschlusskabels sind aufwändig.

Aus der DE 203 18 266 U1 ist eine Vorrichtung zur Strommessung bekannt, bei der ein Shunt und eine Auswerteelektronik durch federnde Kontaktelemente über eine Lötverbindung elektrisch miteinander verbunden sind. Eine direkte Verbindung des Shunts mit einer Batterieklemme ist nur mit verhältnismäßig großem Aufwand möglich.

Die DE 10 2006 019 497 A1 zeigt eine Sensorvorrichtung für eine Starterbatterie, bei der ein Shunt mit einer Hartlotverbindung an einem Polklemmenelement befestigt ist. Die Befestigung muss mechanisch stabil ausgeführt sein. Zur weiteren Befestigung sind entweder separate Teile oder ein Gehäuse aus Spritzguss vorgesehen, das die gesamte Sensorvorrichtung und Teile einer Anschlussklemme umschließt.

Nach der DE 10 2004 055 847 A1 ist eine Batteriesensoranordnung mit einem Shunt bekannt, bei der eine stoffschlüssige und elektrische Leitung zwischen einem ersten Anschluss des Shunts und einem Massekabel sowie eine elektrisch isolierende, kraftoder formschlüssige Verbindung zwischen dem Shunt und einem Trägerelement hergestellt ist.

Nach der DE 10 2004 046 855 B3 ist als Befestigungselement ein separater Bolzen vorgesehen.

Weitere Vorrichtungen zur Strommessung sind in der DE 199 61 311 A1 und der US 2007/0194747 A1 beschrieben.

Aufgabe der Erfindung ist es, eine Vorrichtung zur Strommessung so zu verbessern, dass ein Anschluss, z.B. eine Batterieklemme preiswert angeschlossen werden kann und dabei in der Lage ist, auftretende Kräfte aufzunehmen.

Die Aufgabe ist durch die Merkmale des Anspruchs 1 gelöst. An dem Gehäuse ist ein Niet angeformt, mit dem der erste Anschluss an dem Gehäuse befestigbar ist. Hierdurch wird die elektrisch/mechanische Verbindung zwischen dem ersten Anschluss und dem Messwiderstand deutlich entlastet, so dass diese entsprechend einfach ausgeführt werden kann. Trotzdem werden die auftretenden Kräfte, die besonders aus der mindestens einen an dem zweiten Anschluss befestigten Leitung resultieren, sicher aufgefangen. Insbesondere ersetzt der Niet bisher verwendete Schraubverbindungen, so dass hier die Material- und Montagekosten reduziert werden. Gleichzeitig wirkt das Gehäuse an den relevanten Stellen als Isolator zwischen dem ersten Anschluss und dem Messwiderstand.

Die Unteransprüche betreffen die vorteilhafte Ausgestaltung der Erfindung.

Wenn das Gehäuse im Bereich des Niets den Messwiderstand durchdringt, wird die Stabilität der Vorrichtung insgesamt erhöht.

Eine Lötverbindung zwischen dem ersten Anschluss und dem Messwiderstand ist einfach herzustellen und gewährleistet eine gute elektrische Verbindung.

Anhand der beigefügten Zeichnungen wird die Erfindung nachfolgend näher erläutert. Dabei zeigt:

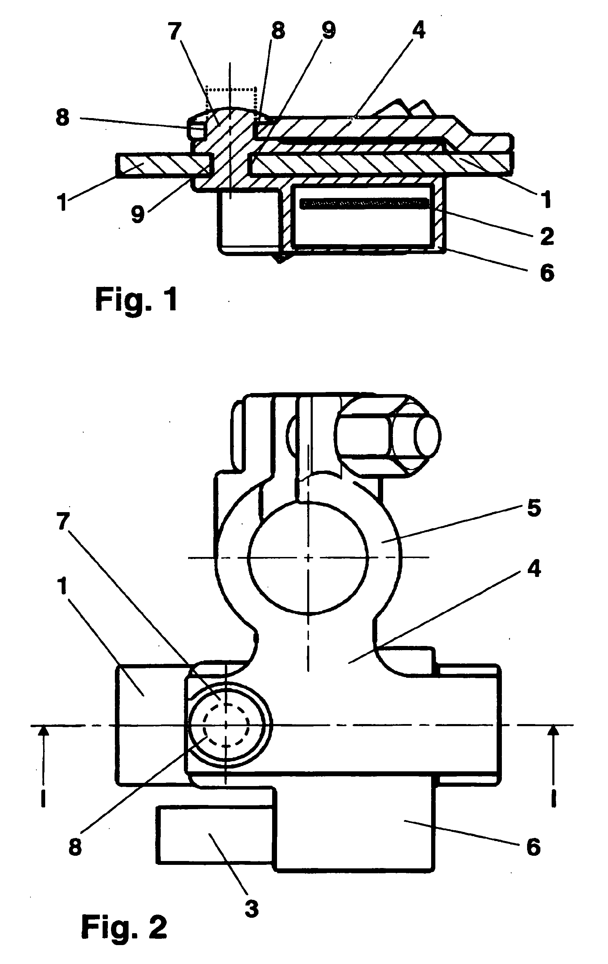

- Fig. 1: einen Querschnitt durch eine erfindungsgemäße Vorrichtung und
- Fig. 2: eine Draufsicht auf die Vorrichtung.

Wie aus den Figuren ersichtlich umfasst eine Vorrichtung zur Strommessung einen Messwiderstand 1 und eine Leiterplatte 2, mit der nicht dargestellte elektrische und/oder elektronische Bauteile eine Auswerteelektronik bilden. Der quaderförmige Messwiderstand 1 und die Leiterplatte 2 sind an zwei in Längsrichtung des Messwiderstands 1 beabstandeten Stellen elektrisch verbunden. Mindestens zwei elektrische Leitungen 3 bilden einen Ausgang von der Leiterplatte 2 zu einem übergeordneten Bordcomputer eines Kraftfahrzeugs.

An einem ersten, nach den Figuren rechten Ende des Messwiderstands 1 ist als erster Anschluss ein Klemmenkörper 4 elektrisch leitend befestigt. Der Klemmenkörper 4 weist im Bereich des Messwiderstands 1 einen im Wesentlichen rechteckigen Querschnitt auf, wobei am rechten Ende im Bereich der Befestigung eine kleine Stufe angeordnet ist. Durch diese Stufe ist der Klemmenkörper 4 im Bereich der Befestigung in direktem Kontakt mit dem Messwiderstand 1, während im Übrigen ein im Wesentlichen konstanter Abstand zwischen beiden eingehalten ist. Im Bereich des linken Endes des Klemmenkörpers 4 ist über dem Messwiderstand 1 eine erste Durchgangsbohrung 8 eingelassen. An dem Klemmenkörper 4 ist in der Draufsicht wegweisend von dem Messwiderstand 1 eine Klemme 5 zum Verbinden mit einem Pol eines Akkumulators angeordnet.

An einem zweiten Ende des Messwiderstands 1, das dem ersten gegenüber liegt und in den Figuren links ist, ist ein nicht dargestellter zweiter Anschluss befestigbar. Rechts von seinem zweiten Ende weist der Messwiderstand 1 eine zweite Durchgangsbohrung 9 auf. Diese teilt die Länge des Messwiderstand in etwa im Verhältnis 3 : 7 und hat einen Durchmesser von in etwa der doppelten Höhe des Messwiderstands 1. In montiertem Zustand fluchten die erste und die zweite Durchgangsbohrung 8, 9.

Der Messwiderstand 1 - mit Ausnahme von Bereichen an dem ersten und dem zweiten Ende - sowie die Leiterplatte 2 mit den Bauteilen sind von einem Gehäuse 6 umgeben. Hierbei ist das Gehäuse 6 um die Leiterplatte 2 und den Messwiderstand 1 gespritzt, so dass es diese massiv umschließt und auch die zweite Durchgangsbohrung 9 durchdringt. Auf diese Weise ist gleichzeitig eine elektrische Isolierung zwischen dem Messwiderstand 1 und dem Klemmenkörper 4 gebildet, ausgenommen in dem vorbestimmten Kontaktbereich. Auf einer der Leiterplatte 1 gegenüberliegenden Seite des Messwiderstands 1 ist einstückig mit dem Gehäuse 6 und koaxial zu den Durchgangsbohrungen 8, 9 ein Niet 7 ausgebildet. Der Niet 7 durchdringt die erste Durchgangsbohrung 8 und ist in etwa doppelt so lang wie der Klemmenkörper 4 hoch ist.

Die Vorrichtung zur Strommessung wird wie folgt gefertigt:

Die Leiterplatte 2 wird wie bekannt elektrisch leitend an dem Messwiderstand 1 befestigt. Anschließend werden die Leiterplatte 2 und der Messwiderstand 1 - ausgenommen Bereiche an dessen erstem und zweitem Ende - mit einem geeigneten Kunststoff umspritzt und so das Gehäuse 6 mit dem Niet 7 gebildet. Der Kunststoff ist elektrisch nicht leitend und weist eine ausreichend hohe Festigkeit auf. Die Leitungen 3 sind hierbei aus dem Gehäuse 6 herausgeführt.

In einem weiteren Arbeitsschritt wird der Klemmenkörper 4 an dem ersten Ende des Messwiderstands 1 und dem Gehäuse 6 befestigt. Hierfür wird der Niet 7 in die erste Durchgangsbohrung 8 eingeführt und das erste Ende des Messwiderstands 1 mit dem Klemmenkörper 4 verlötet. Ein hervorstehendes Ende des Niets 7 wird durch Wärme- und Druckeinwirkung zu einem Kopf verformt, der spielfrei zu dem Klemmenkörper 4 ist.

Der zweite Anschluss wird an dem zweiten Ende des Messwiderstands 1 entweder vormontiert oder bei der Montage des Kraftfahrzeugs befestigt.

## Patentansprüche

1. Vorrichtung zur Strommessung an einem Akkumulator eines Kraftfahrzeugs, mit einem Messwiderstand (1),
mit einer Auswerteelektronik, die mit dem Messwiderstand (1) elektrisch verbunden und von einem Gehäuse (6) umgeben ist,
mit einem ersten Anschluss (4) des Messwiderstands (1) zu einem Pol des Akkumulators und
mit einem zweiten Anschluss des Messwiderstands (1) zu mindestens einem Verbraucher,
wobei das Gehäuse (6) als Kunststoff- Gussgehäuse hergestellt ist, bei dem die gesamte Auswerteelektronik zusammen mit einem Teil des Messwiderstands (1) verspritzt ist,
**dadurch gekennzeichnet, dass** an dem Gehäuse (6) ein Niet (7) einstückig mit dem Gehäuse angeformt ist, mit dem der erste Anschluss (4) an dem Gehäuse (6) befestigbar ist.

2. Vorrichtung zur Strommessung nach Anspruch 1, **dadurch gekennzeichnet, dass** das Gehäuse (6) im Bereich des Niets (7) den Messwiderstand (1) durchdringt.

3. Vorrichtung zur Strommessung nach Anspruch 1 oder 2, **dadurch gekennzeichnet, dass** der erste Anschluss (4) an einem dem Niet (7) gegenüber liegenden Ende mit dem Messwiderstand (1) verlötet ist.

## Claims

1. Device for current measurement on an accumulator of a motor vehicle,
having a precision resistor (1),
having an evaluation electronics being electrically connected to the precision resistor (1) and being encased by a housing (6),
having a first connection (4) of the precision resistor (1) with a terminal of the accumulator and
having a second connection of the precision resistor (1) to at least one consumer,
wherein the housing (6) is produced as an injection-molded plastic housing in which the entire evaluation electronics is molded together with part of the precision resistor (1),
**characterized in that** a rivet (7), with which the first connection (4) can be fastened to the housing (6), is integrally molded onto the housing (6).

2. Device for current measurement according to Claim 1, **characterized in that** the housing penetrates the precision resistor (1) in the region of the rivet (7).

3. Device for current measurement according to Claim 1 or 2, **characterized in that** the first connection (4) is soldered to the precision resistor (1) at an end opposite the rivet (7).

## Revendications

1. Dispositif de mesure du courant sur un accumulateur d'un véhicule automobile
avec une résistance de mesure (1),
avec une électronique d'exploitation qui est reliée électriquement à la résistance de mesure (1) et qui est entourée d'un boîtier (6),
avec une première connexion (4) de la résistance de mesure (1) à une borne de l'accumulateur et
avec une deuxième connexion de la résistance de mesure (1) à au moins un consommateur,
le boîtier (6) étant réalisé en tant que boîtier en matière plastique moulé sur lequel l'électronique d'exploitation globale est surmoulée avec une partie de la résistance de mesure (1),
**caractérisé en ce qu'**
un rivet (7) est formé solidairement sur le boîtier (6) avec lequel la première connexion (4) peut être montée sur le boîtier (6).

2. Dispositif de mesure du courant selon la revendication 1, **caractérisé en ce que** le boîtier (6) pénètre la résistance de mesure (1) dans la zone du rivet (7).

3. Dispositif de mesure du courant selon la revendication 1 ou 2, **caractérisé en ce que** la première connexion (4) est soudée à la résistance de mesure (1) sur un bout opposé au rivet (7).
